Europäisches Patentamt

European Patent Office

Office européen des brevets

(19)

(11) Numéro de publication: **0 313 450**
**A1**

## DEMANDE DE BREVET EUROPEEN

(12)

(21) Numéro de dépôt: **88402614.7**

(22) Date de dépôt: **17.10.88**

(51) Int. Cl.4: **G 01 R 33/035**

(30) Priorité: **20.10.87 FR 8714454**

(43) Date de publication de la demande:
**26.04.89 Bulletin 89/17**

(84) Etats contractants désignés:
**BE DE ES GB IT NL SE**

(71) Demandeur: **THOMSON-CSF**
**173, Boulevard Haussmann**
**F-75379 Paris Cédex 08 (FR)**

(72) Inventeur: **Stephan, Ronan**
**THOMSON - CSF SCPI - 19, avenue de Messine**
**F-75008 Paris (FR)**

**Doisy, Martine**
**THOMSON - CSF SCPI - 19, avenue de Messine**
**F-75008 Paris (FR)**

**Monfort, Yves**
**THOMSON - CSF SCPI - 19, avenue de Messine**
**F-75008 Paris (FR)**

**Robbes, Didier**
**THOMSON - CSF SCPI - 19, avenue de Messine**
**F-75008 Paris (FR)**

**Lamshock, Marc**
**THOMSON - CSF SCPI - 19, avenue de Messine**
**F-75008 Paris (FR)**

**Bloyet, Daniel**
**THOMSON - CSF SCPI - 19, avenue de Messine**
**F-75008 Paris (FR)**

**Provost, Jackie**
**THOMSON - CSF SCPI - 19, avenue de Messine**
**F-75008 Paris (FR)**

**Raveau, Bernard**
**THOMSON - CSF SCPI - 19, avenue de Messine**
**F-75008 Paris (FR)**

(74) Mandataire: **Desperrier, Jean-Louis et al**
**THOMSON-CSF SCPI**
**F-92045 PARIS LA DEFENSE CEDEX 67 (FR)**

(54) Dispositif magnétométrique supraconducteur.

(57) L'invention concerne les dispositifs magnétométriques supraconducteurs utilisant un composé supraconducteur à la température de l'azote liquide.

Elle consiste à utiliser comme élément sensible un barreau (101) de matériau supraconducteur présentant une constriction (102, 103) centrale permettant de délimiter un chenal (104) dans lequel le nombre de boucles intrinsèques utiles est suffisamment limité pour que l'élément sensible se comporte comme un SQUID DC à boucle unique.

Elle permet de réaliser des magnétomètres du type SQUID DC fonctionnant à la température de l'azote liquide.

FIG_1

EP 0 313 450 A1

Bundesdruckerei Berlin

Description

### < DISPOSITIF MAGNETOMETRIQUE SUPRACONDUCTEUR

La présente invention se rapporte aux dispositifs magnétométriques supraconducteurs utilisant l'effet JOSEPHSON, connus sous le nom de SQUID.

Il est connu d'utiliser un matériau supraconducteur pour réaliser un dispositif magnétométrique utilisant l'effet JOSEPHSON et permettant de déceler des champs magnétiques aussi petits que $10^{-15}$ Tesla/$\sqrt{}$Hz. On trouvera l'état de l'art concernant cette technique dans un article publié par BRIAN WILLIAM PETLEY dans le numéro 133 de **LA RECHERCHE** paru en mai 1982. Les matériaux supraconducteurs connus jusqu'à une époque récente ne présentaient un tel effet supraconducteur que pour des températures très basses, de l'ordre de quelques degrés Kelvin, ce qui obligeait à les refroidir à l'hélium liquide. Il fallait alors pour cela utiliser des cryostats encombrants et fragiles et dont le fonctionnement était coûteux.

On a découvert depuis peu des matériaux tels que $Y\,Ba_2\,Cu_3\,O_{8-x}$ qui présentent une température critique de transition supraconductrice de l'ordre de 93 K et peuvent donc fonctionner dans l'azote liquide, dont la température d'ébullition est de 77 K.

GOUCH et al, de l'Université de Birmingham, ont remplacé la boucle en niobium d'un SQUID radiofréquence (RF) du commerce par un anneau fabriqué avec un tel matériau et ont montré l'existence de boucles intrinsèques dans cet anneau.

De même PEGRUM et DONALDSON, de l'Université de Strathclyde, ont remplacé cette boucle en niobium par un simple morceau de matériau nouveau de forme grossièrement parallélépipédique, et on montré l'existence de boucles intrinsèques à l'intérieur de ce matériau permettant d'espérer pouvoir détecter des champs de l'ordre de $10^{-8}$ à $10^{-10}$T.

Dans ces expériences la sensibilité est limitée par un bruit qui amène une dispersion et une incertitude importantes. Ce bruit est imputé à l'existence de boucles multiples au sein du matériau, amenant à des périodes multiples qui se superposent de manière aléatoire. KOCH et al, du Centre de Recherches IBM de Yorktown Heights, ont fabriqué un SQUID utilisant comme élément sensible un film mince de ce nouveau matériau, usiné par implantation ionique pour former une boucle adéquate. Contrairement aux expériences ci-dessus, ce SQUID est du type continu (DC) et fonctionne donc avec une polarisation en courant continu. Toutefois il n'a pas été possible d'obtenir un fonctionnement supraconducteur au-dessus de 68 K, et les résultats obtenus montrent clairement que la boucle utilisée était uniquement supraconductrice sur une petite portion et que les courbes s'apparentent en fait à un réseau de jonctions à transition mal définie dans lesquelles l'effet observé correspond à une commutation résistive assistée par l'effet Joule du conducteur normal alentour.

Selon l'invention on utilise comme élément sensible d'un SQUID DC un fragment de matériau supraconducteur à des températures au moins égales à celles d'ébullition de l'azote liquide, ce fragment présentant une constriction centrale qui permet d'obtenir un comportement équivalent à celui d'une boucle unique.

D'autres particularités et avantages de l'invention apparaîtront clairement dans la description suivante présentée à titre d'exemples non limitatifs en face des figures annexées qui représentent:

- la figure 1, une vue en perspective cavalière d'un élément sensible selon l'invention ;
- la figure 2, une vue agrandie de la partie centrale de cet élément ;
- la figure 3, un schéma d'un SQUID utilisant cet élément ;
- la figure 4, une courbe caractéristique du SQUID ; et
- la figure 5, une courbe d'interférence du SQUID.

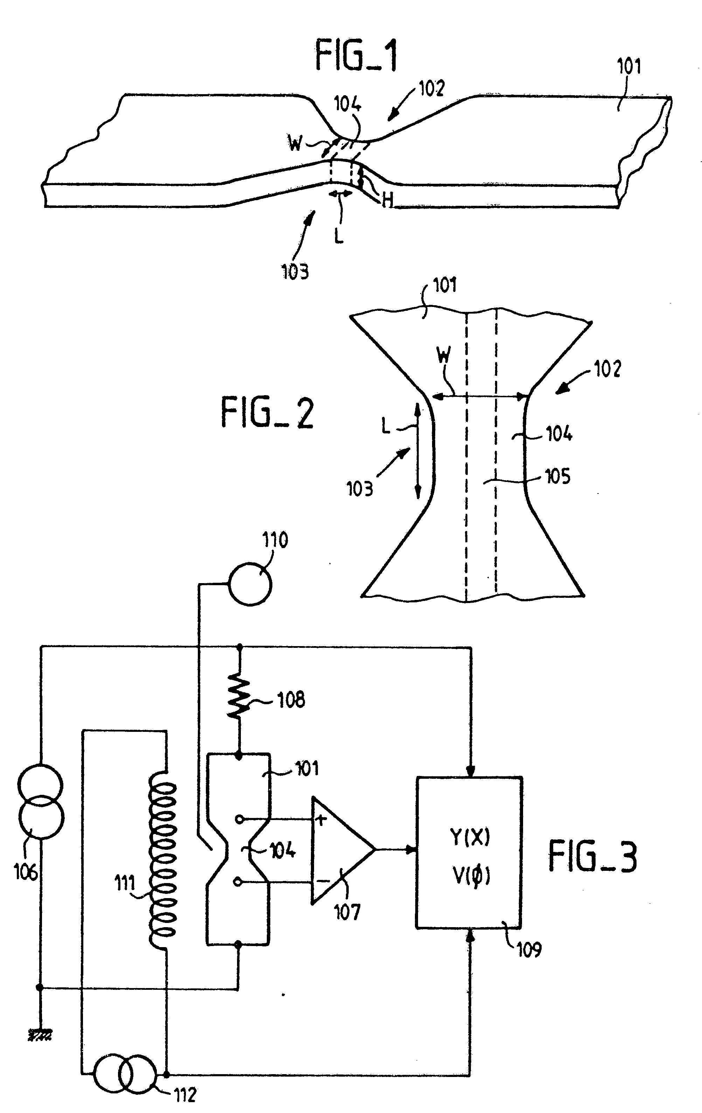

On a représenté sur la figure 1 l'élément sensible d'un SQUID selon l'invention. Celui-ci est formé d'un barreau de $YBa_2\,Cu_3O_{8-x}$ d'environ 1cm de long sur 5mm de large. Ces dimensions sont relativement peut importantes, l'essentiel étant que ce barreau présente vers son milieu une constriction formée de deux entailles en forme de V 102 et 103. Ces entailles sont obtenues par exemple par sablage à travers un masque métallique ou à l'aide d'un laser pulsé. La forme elle-même de ces entailles est d'une importance minime, l'essentiel étant qu'elles délimitent un canal sensiblement linéaire de largeur W, de longueur L, et d'épaisseur H. L'épaisseur H correspond à l'épaisseur du barreau 101 lorsque celle-ci est suffisamment faible, par exemple de 0,2 mm. Pour cela le barreau H peut être découpé dans une plaquette présentant cette même épaisseur par fabrication, ou usiné par rodage jusqu'à obtenir cette épaisseur. On peut également, si on dispose d'un barreau d'une épaisseur trop grande, usiner celui-ci pour former deux autres entailles en V sur les faces supérieure et inférieure de celui-ci, afin d'obtenir l'épaisseur voulue du canal central. Dans une réalisation préférée, cette largeur et cette longueur sont respectivement W = 0,5 mm et L = 0,3 mm.

Afin de réduire encore les dimensions de la partie active du canal, on traite, selon un procédé connu, les parois de celui-ci en appliquant aux extrémités du barreau 101 des impulsions brèves et intenses de courant (quelques µs et quelques µA). En raison de l'effet de peau, ces impulsions de courant amènent à la température de fusion la surface des grains à la surface du barreau, ce qui modifie les jonctions intergrains et abaisse localement la température critique. On arrive ainsi à délimiter dans le canal un chenal actif central 105, représenté sur la figure 2, dont la largeur est de préférence de l'ordre de 0,1 mm.

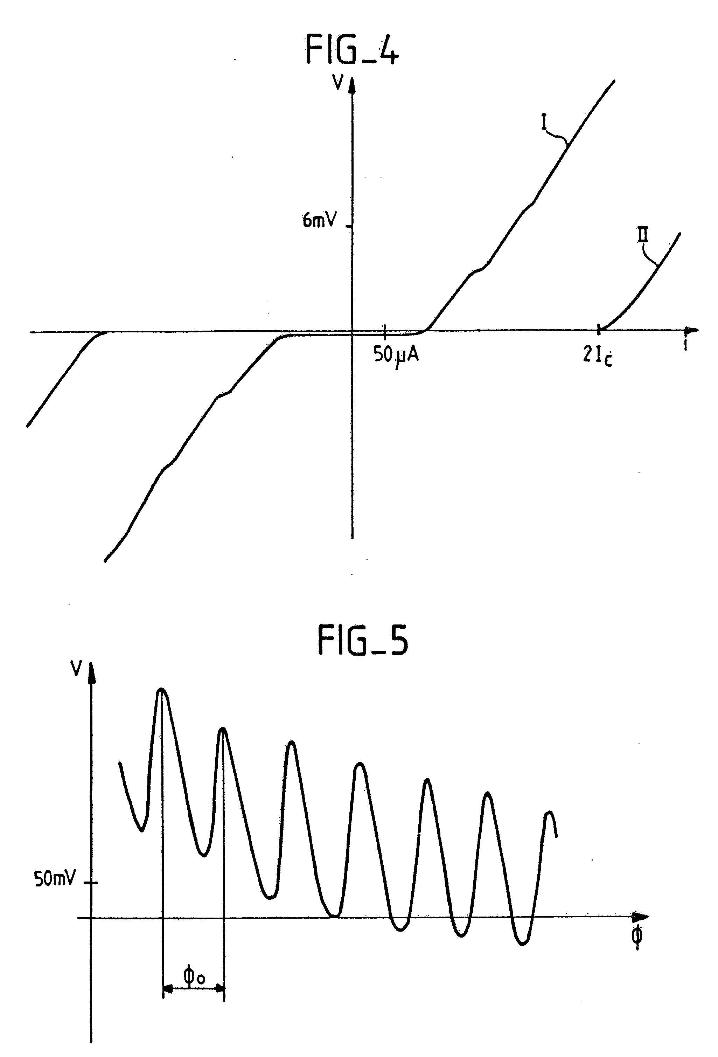

On remplace alors par ce barreau la boucle de niobium d'un SQUID DC connu dont on a représenté le schéma sur la figure 3.

Dans ce dispositif le barreau 101 est alimenté en courant continu entre ses extrémités par une source de courant réglable 106. La tension en amont et en aval de la constriction 104 est prélevée par deux électrodes reliées aux entrées + et -d'un amplificateur différentiel 107 moyennant une adaptation d'impédance . Une résistance 108 placée en série entre le barreau 101 et le générateur 106 permet de déterminer la valeur du courant dans le barreau. Un dispositif de visualisation 109, relié d'une part à cette résistance 108 et d'autre part à la sortie de l'amplificateur 107, permet d'obtenir la courbe Y(X) représentant les variations de la tension aux bornes du canal 104 en fonction du courant parcourant le barreau 101.

On a représenté sur la figure 4 ces courbes tension/intensité dans deux cas particuliers :

La courbe I correspond à une expérience particulière destinée à mettre en évidence les manifestations de l'effet JOSEPHSON dans le barreau 101. Pour cela, on a rajouté au dispositif de la figure 3 un générateur 110 de champ radiofréquence à 8,6 GHz, dont le signal est appliqué sur le barreau 101. Sous l'effet de ce champ on obtient la courbe I qui présente des échelons connus sous le nom de marches de Shapiro, qui sont caractéristiques de la manifestation de l'effet JOSEPHSON et dont la hauteur montre qu'on n'a pas de jonctions en série. La netteté de cette courbe, ainsi que celle des suivantes, montre bien que le dispositif se comporte comme si l'on avait une boucle unique comportant des jonctions ordonnées, sur une dynamique de flux de quelques dizaines de $\varphi_0$.

La courbe II est obtenue en faisant croître sans champ radiofréquence le courant d'une valeur négative à une valeur positive dans des limites suffisamment larges pour dépasser le courant critique Ic des jonctions à partir duquel le matériau cesse d'être supraconducteur. Ce courant critique se décèle par l'apparition d'une tension qui n'est plus nulle, puisque la résistance passe d'une valeur nulle à une valeur finie.

Dans l'exemple de réalisation décrit la valeur de courant critique Ic est sensiblement de 175$\mu$ A. Pour pouvoir utiliser le dispositif en magnétomètre, on règle alors le courant délivré par le générateur 106 à une valeur constante très légèrement supérieure au courant critique. A l'aide d'une bobine 111, alimentée par un générateur 112, on place ensuite le barreau 101 dans un champ magnétique variable. Les effets de ce champ magnétique se combinent aux effets du champ magnétique intrinsèque apporté par le courant circulant dans le barreau et viennent donc modifier la valeur du courant critique. En appliquant alors la mesure de l'intensité délivrée par le générateur 112, qui est proportionnelle au champ de la bobine, au dispositif de visualisation 109, on obtient la courbe représentant la valeur de la tension aux bornes du canal 104 en fonction du flux $\varphi$ circulant dans le barreau, qui est proportionnel au champ de la bobine. Cette courbe est appelée figure d'interférence.

La bobine 111 peut être constituée par exemple par un solénoïde à l'intérieur duquel est placé le barreau 101, ou par deux bobines de Helmoltz entourant ce barreau. On a constaté que l'orientation de cette bobine 111 avait peu d'influence sur les résultats, ce qui correspond à une certaine isotropie de la mesure du champ.

En alimentant la bobine 111 avec un courant alternatif de fréquence comprise entre 10 Hz et 100 Khz, on obtient donc la courbe V ($\varphi$) représentée sur la figure 5, dans laquelle la période des ondulations correspond au quantum $\varphi_0$ de flux dans la boucle SQUID équivalente du barreau.

Le champ à mesurer vient contrarier l'influence du champ apporté par la bobine 111, et provoque donc une modulation de la tension V. Pour mesurer ce champ, on choisit un point de fonctionnement sur la courbe de la figure 5 en un endroit où la variation de la tension en fonction de la variation du champ est maximale, c'est-à-dire en un endroit on a dV/d$\varphi$ maximale. Cet endroit correspond manifestement sur la figure au centre de l'un des flancs montants de l'une des ondulations. La valeur exacte est fonction de l'élément sensible utile et est fixée par étalonnage.

Ce champ continu est obtenu en appliquant à l'aide du générateur 112 un courant continu dans la bobine 111.

Le barreau 101 étant ainsi polarisé en intensité et en champ, on fait osciller légèrement le champ appliqué par la bobine 111 en modulant le générateur 112 de manière à avoir une amplitude de champ légèrement inférieure à $\varphi_0$/2, ce qui permet de faire décrire à la tension V une amplitude correspondant à l'amplitude d'un flanc avant d'une ondulation. Dans l'exemple décrit l'amplitude du champ était de $4.10^{-7}$T.

Le champ à mesurer superposé alors au champ de polarisation apporté par la bobine 111 provoque un décalage du point moyen du champ total appliqué au barreau 101, et donc une modification très rapide de la tension de sortie de l'amplificateur 107, puisque l'on dépasse d'un côté ou de l'autre une des extrémités de l'ondulation, à l'une des limites de l'excursion du champ magnétique alternatif.

Les mesures, dans l'exemple de réalisation décrit, ont donné une sensibilité dV/d$\varphi$ égale à 30$\mu$V/$\varphi_0$ et un bruit inférieur à 0,1nV/$\sqrt{}$Hz. Ce bruit correspond d'ailleurs essentiellement au bruit de l'électronique utilisée et pourrait être diminué en utilisant une électronique plus performante. Dans l'exemple décrit, le bruit de cet amplificateur était de 4,4 nV/$\sqrt{}$Hz à 10 HZ.

A partir des dimensions de l'installation et des résultats de mesure, ainsi que des mesures de granulométrie du matériau, on a pu estimer le diamètre efficace moyen de la boucle SQUID à 50$\mu$m .

Dans ces conditions on obtient une sensibilité de champ sensiblement 0,1 pT$\sqrt{}$Hz et une sensibilité en flux en zone de bruit blanc d'environ $3.10^{-6}\varphi_0/\sqrt{}$Hz.

Le dispositif ainsi décrit est donc un capteur de type SQUID DC fonctionnant à la température de l'azote liquide et utilisant les jonctions JOSEPHSON intrinsèques au matériau massif. La géométrie utilisée pour ce matériau permet d'annuler la superposition des signaux provenant d'un grand nombre de boucles indépendantes et de se polariser sur une seule jonction.

Les sensibilités obtenues sont bien meilleures que celles des meilleures SQUID RF utilisés dans l'hélium liquide et sont équivalentes à celles d'un bon SQUID DC fonctionnant lui aussi dans l'hélium liquide.

**Revendications**

1. Dispositif magnétométrique supraconducteur, du type SQUID DC, comprenant un élément sensible supraconducteur (101), des premiers moyens de polarisation (106) pour faire circuler un courant continu dans cet élément sensible, des deuxièmes moyens de polarisation (111, 112) pour soumettre l'élément sensible à un champ magnétique de polarisation, et des moyens (107) pour mesurer la tension apparaissant sur l'élément sensible, caractérisé en ce que cet organe sensible est une pièce (101) de matériau supraconducteur à une température au moins égale à celle de l'azote liquide et présentant une constriction (102) permettant de limiter le nombre de boucles intrinsèques utiles dans le matériau et d'obtenir un corportement équivalent à celui d'une boucle unique.

2. Dispositif selon la revendication 1, caractérisé en ce que la pièce (101) de matériau supraconducteur a sensiblement la forme d'un barreau plat présentant une constriction centrale formée de deux entailles en V (102, 103) creusées face à face sur les grands côtés du barreau pour déterminer un canal central (104).

3. Dispositif selon la revendication 2, caractérisé en ce que les flancs du canal sont traités pour que l'effet supraconducteur soit superficiellement modifié afin de délimiter un chenal central (105) plus étroit que le canal.

4. Dipositif selon l'une quelconque des revendications 2 et 3, caractérisé en ce que le barreau (101) est relativement épais et qu'il comprend deux entailles creusées sur ses faces supérieure et inférieure perpendiculairement aux entailles en V (102, 103) de manière à réduire l'épaisseur du barreau au niveau due canal.

5. Dispositif selon l'une quelconque des revendications 2 à 4, caractérisé en ce que l'épaisseur (H) du canal est sensiblement égale à 0,2 mm, que sa longueur est sensiblement égale à 0,3 mm et sa largeur (W) sensiblement égale à 0,5 mm.

6. Dispositif selon l'une quelconque des revendications 3 à 5, caractérisé en ce que la largeur du chenal actif (105) délimitée par les parois traitées est sensiblement égale à 0,1 mm.

# FIG_1

# FIG_2

# FIG_3

# FIG_4

# FIG_5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | JAPANESE JOURNAL OF APPLIED PHYSICS, vol. 26, no. 7, part II, pages L.1211-L.1213, Tokyo, JP; Y. HIGASHINO et al.: "Observation of the Josephson effect in Y-Ba-Cu-O compound" * Page L.1211, colonne 2, lignes 2-18; Page L-1213, colonne 1, lignes 1-13; figure 2 * | 1 | G 01 R 33/035 |
| Y | APPLIED PHYSICS LETTERS, vol. 51, no. 3, 20 juillet 1987, pages 200-202, American Institute Physics, New York, US; R.H. KOCH et al.: "Quantum interference devices made from superconducting oxide thin films" * Résumé; page 201, colonne 1, lignes 17-39; figure 1 * | 1 | |
| A | PHYSICAL REVIEW B: CONDENSED MATTER, vol. 33, no. 7, 1 avril 1986, pages 5114-5117, The American Physical Society, Woodbury, New York, US; M. BÜTTIKER et al.: "Flux sensitivity of a piecewise normal and superconducting metal loop" * Résumé * | 1 | |
| A | GEC JOURNAL OF RESEARCH, vol. 2, no. 4, 1984, pages 205-217, Chelmsford, Essex, GB; B.R. BARNARD: "Applications of the Josephson Junction" * Page 207, colonne 2, lignes 10-23 * | 1 | |
| A | US-A-3 528 005 (A.L. MORSE et al.) * Colonne 4, ligne 74 - colonne 6, ligne 32; figures 1,2 * | 1 | |

**DOMAINES TECHNIQUES RECHERCHES (Int. Cl.4)**

G 01 R 33
H 01 L 39

Le présent rapport a été établi pour toutes les revendications

| Lieu de la recherche | Date d'achèvement de la recherche | Examinateur |
|---|---|---|
| LA HAYE | 23-01-1989 | HAASBROEK J.N. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant